# EUROPEAN PATENT APPLICATION

(11) **EP 4 693 373 A1**
(43) Date of publication of application: **11.02.2026**
(21) Application number: 24778758.3
(22) Date of filing: 13.02.2024
(51) Int. Cl.: H01L 21/304, B23Q 11/00, B24B 37/00, C09K 3/14, C11D 1/29, C11D 3/12, C11D 3/20, C11D 3/43

(54) **POLISHING AND WASHING METHOD, WASHING AGENT, AND SET OF POLISHING COMPOSITION AND WASHING AGENT**

(30) Priority: 29.03.2023 JP 2023052626
(71) Applicant: Fujimi Incorporated, Kiyosu-shi, Aichi 452-8502 (JP)
(72) Inventor: NAKAGAI, Yuichiro, Kiyosu-shi, Aichi 452-8502 (JP); ODA, Hiroyuki, Kiyosu-shi, Aichi 452-8502 (JP)
(74) Representative: Grünecker Patent- und Rechtsanwälte PartG mbB
(86) International application number: PCT/JP2024/004810
(87) International publication number: WO 2024/202613

(57) **Abstract**

The present invention provides a means configured to sufficiently remove residues present on a polished silicon carbide substrate surface.

The present invention is a method of polishing and cleaning a silicon carbide substrate, the method comprising the steps of: supplying a polishing composition to a silicon carbide substrate and polishing the silicon carbide substrate; and cleaning the polished silicon carbide substrate by using a cleaner, wherein the cleaner comprises a chelating agent, a surfactant, and a solvent, and wherein the solvent consists of water.

## Description

### TECHNICAL FIELD

The present invention relates to a method of polishing and cleaning, a cleaner, and a set containing a polishing composition and a cleaner.

### BACKGROUND ART

Surfaces of materials (e.g., metals, semi-metals, non-metals, oxides thereof) are polished using a polishing composition. For example, a surface composed of silicon carbide is processed by lapping, which is performed by supplying a diamond abrasive between the surface and a polishing table. However, lapping with a diamond abrasive is prone to cause defects and distortion due to generation and persistence of scratches and dents. Thus, polishing is performed by using a polishing pad and a polishing composition after or instead of lapping with a diamond abrasive.

WO 2022/168859, for example, discloses, as such a polishing technology, a method of polishing a polishing target having a surface composed of silicon carbide using a polishing composition containing an abrasive, a permanganate, a metal salt, namely a salt of a metal cation of which a hydrated metal ion has a pKa of less than 7.0 and an anion, and water. According to the technology described in Patent Literature 1, it is possible to suppress the rise in pH of the polishing composition and the rise in temperature of the polishing pad and also to increase the polishing removal rate.

### SUMMARY OF INVENTION

However, after polishing by the technology described in WO 2022/168859, particles derived from an abrasive, etc., and metals (and/or metal ions), etc., derived from the metal salt contained in the polishing composition may remain on the surface of the polishing target. These residues may cause a problem. Therefore, it is necessary to remove these residues sufficiently after polishing.

Here, the purpose of the present invention is to provide a means configured to sufficiently remove residues present on a polished silicon carbide substrate surface. Another related purpose is to provide a cleaner and a set containing a polishing composition and a cleaner used for the above means. Still another related purpose is to provide a method of cleaning the above silicon carbide substrate.

The present inventors have conducted intensive research to solve the above-mentioned problems, and as a result, have found that the above problems can be solved by a method of polishing and cleaning a silicon carbide substrate, the method containing the steps of: supplying a polishing composition to a silicon carbide substrate and polishing the silicon carbide substrate; and cleaning the polished silicon carbide substrate by using a cleaner, wherein the cleaner contains a chelating agent, a surfactant, and a solvent, and wherein the solvent consists of water. The present invention has then been completed.

### DESCRIPTION OF EMBODIMENTS

An embodiment of the present invention provides a method of polishing and cleaning a silicon carbide substrate, the method containing the steps of: supplying a polishing composition to a silicon carbide substrate and polishing the silicon carbide substrate; and cleaning the polished silicon carbide substrate by using a cleaner, wherein the cleaner contains a chelating agent, a surfactant, and a solvent, and wherein the solvent consists of water. Such a method may be used to sufficiently remove residues present on a polished silicon carbide substrate surface.

The detailed reason why the above effect can be obtained by the method of the present invention is unknown, but is considered to be due to the following reasons.

On the surface of a silicon carbide substrate as polished using a polishing composition, particle residues derived from an abrasive, etc., contained in the polishing composition and metal ion residues derived from the metal salt contained in the polishing composition are present. The chelating agent contained in the cleaner used in the method of the present invention can perform multidentate coordination to metal ions and increase the solubility of the metal ions in the cleaner. In addition, the surfactant contained in the cleaner facilitates the removal of particle residues such as an abrasive. From the above, it is considered that the method of the present invention using a cleaner containing a chelating agent and a surfactant can sufficiently remove residues present on a polished silicon carbide substrate surface.

Note that the above mechanisms are based on speculation, and the technical scope of the present invention is not limited by the mechanisms in any way.

Hereinafter, embodiments of the present invention will be described in detail. The present invention, however, is not limited solely to the following embodiments, but may be modified in various ways within the scope of the Claims. The embodiments described herein may be optionally combined to make other embodiments. Unless otherwise specified herein, all operations and measurements of physical properties, etc., are performed under conditions at room temperature (20°C or more and 25°C or less)/relative humidity (RH) of 40%RH or more and 50%RH or less.

### [Silicon carbide substrate]

The technology disclosed herein encompasses a method of cleaning a substrate made of silicon carbide (hereinafter, also referred to as "silicon carbide substrate", "SiC substrate", or "SiC wafer"), and more specifically, a method of polishing and cleaning the above silicon carbide substrate. Thus, the above silicon carbide substrate is not only a substrate to be cleaned but also a substrate to be polished. According to the method disclosed herein, the surface of the above silicon carbide substrate is well cleaned.

The method disclosed herein can be applied to cleaning after polishing a mechanically and chemically stable single crystal silicon carbide surface. Silicon carbide is expected to be a semiconductor substrate material with low power loss and excellent heat resistance, etc. Improving the surface properties of silicon carbide is of great practical benefit. There is also a significant advantage in cleaning a surface that has been polished to a high surface quality so as to achieve a clean surface finish.

### [Cleaner]

### <Chelating agent>

The cleaner disclosed herein contains a chelating agent. It is considered that the chelating agent can perform multidentate coordination to metal ions and increase the solubility of the metal ions in the cleaner.

Examples of the type of chelating agent include, but are not limited to, a hydroxy acid, a dicarboxylic acid, an aminocarboxylic acid-based chelating agent or an organic phosphonic acid-based chelating agent. The chelating agent may or may not contain a carboxy group in the molecule. In addition, the chelating agent may or may not contain a hydroxy group in the molecule. Further, the chelating agent may or may not contain an amino group in the molecule.

In the cleaner disclosed herein, the chelating agent preferably contains a carboxy group in the molecule. Examples of the carboxy group-containing chelating agent include a hydroxy acid, a dicarboxylic acid, or an aminocarboxylic acid-based chelating agent. Among them, the chelating agent preferably contains a hydroxy acid. Here, the hydroxy acid refers to an organic compound having a carboxy group(s) and a hydroxy group(s) per molecule. The hydroxy acid may contain one carboxy group or multiple carboxy groups. When the hydroxy acid contains multiple carboxy groups, the hydroxy acid may contain two or more carboxy groups or three or more carboxy groups. The hydroxy acid may contain one hydroxy group or multiple hydroxy groups. When the hydroxy acid contains multiple hydroxy groups, the hydroxy acid may contain two or more hydroxy groups or three or more hydroxy groups. Examples of the hydroxy acid include, but are not particularly limited to, an aliphatic hydroxy acid or an aromatic hydroxy acid.

Examples of the aliphatic hydroxy acid include glycolic acid, hydroxypropionic acid, hydroxybutanoic acid, hydroxypentanoic acid, hydroxyhexanoic acid, hydroxyheptanoic acid, hydroxynonanoic acid, hydroxydecanoic acid, hydroxyundecanoic acid, hydroxydododecanoic acid, hydroxytridecanoic acid, hydroxytetradecanoic acid, hydroxypentadecanoic acid, hydroxyhexadecanoic acid, hydroxyheptadecanoic acid, hydroxyoctadecanoic acid, hydroxynonadecanoic acid, hydroxyicosanoic acid, hydroxydocosanoic acid, hydroxytetradocosanoic acid hydroxyhexadocosanoic acid, hydroxyoctadocosanoic acid, lactic acid, tartronic acid, glyceric acid, hydroxybutyric acid, 2-hydroxybutyric acid, 3-hydroxybutyric acid, γ-hydroxybutyric acid, malic acid, tartaric acid, citramalic acid, citric acid, isocitric acid, leucinic acid, mevalonic acid, pantothenic acid, ricinoleic acid, ricinelaidic acid, celebronic acid, quinic acid, or shikimic acid. Their isomers are acceptable.

Examples of the aromatic hydroxy acid include: a monohydroxybenzoic acid derivative such as salicylic acid, creosote acid (homosalicylic acid, hydroxy(methyl)benzoic acid), vanillic acid, syringic acid; a dihydroxybenzoic acid derivative such as pyrocatechuic acid, resorcylic acid, protocatechuic acid, gentisic acid, orseric acid; a trihydroxybenzoic acid derivative such as gallic acid; a phenylacetic acid derivative such as mandelic acid, benzylic acid, atrolactinic acid; or a hydrocinnamic acid derivative such as melilotic acid, phloretic acid, cumaric acid, umbelic acid, coffeic acid, ferulic acid, or sinapic acid. Their isomers are acceptable.

One kind of the hydroxy acid may be used singly or two or more kinds thereof may be used in combination. In addition, the hydroxy acid used may be a commercially available or synthetic one.

Among them, an aliphatic hydroxy acid is more preferred, and citric acid is still more preferred.

A dicarboxylic acid may be included as the carboxy group-containing chelating agent. Examples of the dicarboxylic acid include oxalic acid, malonic acid, succinic acid, glutaric acid, adipic acid, pimelic acid, suberic acid, azelaic acid, sebacic acid, phthalic acid, isophthalic acid, or terephthalic acid.

An aminocarboxylic acid-based chelating agent may be included as the carboxy group-containing chelating agent. Examples of the aminocarboxylic acid-based chelating agent include ethylenediaminetetraacetic acid, sodium ethylenediaminetetraacetate, nitrilotriacetic acid, sodium nitrilotriacetate, ammonium nitrilotriacetate, hydroxyethyl ethylenediaminetriacetic acid, sodium hydroxyethyl ethylenediaminetriacetate, diethylenetriamine pentaacetic acid, sodium diethylenetriamine pentaacetate, triethylenetetramine hexaacetic acid, or sodium triethylenetetramine hexaacetate.

The cleaner disclosed herein may contain other chelating agent together with the above carboxy group-containing chelating agent as long as the above effects are not inhibited. Examples of such other chelating agent include an organic phosphonic acid-based chelating agent. Examples of the organic phosphonic acid-based chelating agent include 2-aminoethylphosphonic acid, 1-hydroxyethylidene-1,1-diphosphonic acid, aminotri(methylenephosphonic acid), ethylenediamine tetrakis(methylenephosphonic acid), diethylenetriamine penta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methane hydroxyphosphonic acid, 2-phosphonobutane-1,2-dicarboxylic acid, 1-phosphonobutane-2,3,4-tricarboxylic acid, and α-methylphosphonosuccinic acid. One kind of these other chelating agents may be used singly or two or more kinds thereof may be used in combination.

However, the concentration (content) of the other chelating agent based on the total mass of the hydroxy acid and the other chelating agent is preferably 5 mass% or less, more preferably 3 mass% or less, still more preferably 2 mass% or less, and particularly preferably 1 mass% or less. The most preferred embodiment is one in which the concentration (content) of the other chelating agent is 0 mass%, i.e., any other chelating agents other than the hydroxy acid are not included.

The concentration (content) of the chelating agent in the cleaner is appropriately set within the range where the effect of including the chelating agent is elicited, and is not limited to a specific range. In some embodiments, the concentration (content) of the chelating agent in the cleaner may be 0.01 mass% or more, and 0.1 mass% or more is appropriate. In some embodiments, the concentration (content) of the chelating agent in the cleaner may be 0.3 mass% or more, 0.5 mass% or more, 0.8 mass% or more, 1.0 mass% or more, 1.2 mass% or more, or 1.5 mass% or more. In such embodiments, the upper limit of the concentration (content) of the chelating agent in the cleaner may be 8.0 mass% or less, 6.0 mass% or less, 5.5 mass% or less, 5.0 mass% or less, 4.5 mass% or less, or 4.0 mass% or less.

That is, in some embodiments, the concentration (content) of the chelating agent in the cleaner may be 0.01 mass% or more and 8.0 mass% or less, 0.1 mass% or more and 8.0 mass% or less, 0.3 mass% or more and 6.0 mass% or less, 0.5 mass% or more and 5.5 mass% or less, 0.8 mass% or more and 5.0 mass% or less, 1.0 mass% or more and 4.5 mass% or less, 1.2 mass% or more and 4.0 mass% or less, or 1.5 mass% or more and 4.0 mass% or less.

When the cleaner contains two or more different chelating agents, the concentration (content) of the chelating agent means the total amount of these chelating agents.

### <Surfactant>

The cleaner disclosed herein contains a surfactant. It is thought that the inclusion of a surfactant in the cleaner facilitates the removal of particle residues originating from an abrasive, etc., contained in the polishing composition.

The surfactant used in the cleaner is not particularly limited, and any anionic, cationic, nonionic, or amphoteric surfactant may be used. The surfactant that exhibits good cleaning performance on a polished silicon carbide substrate surface may preferably be selected from among an anionic surfactant and a cationic surfactant, and more preferably an anionic surfactant. One kind of the surfactant may be used singly or two or more kinds thereof may be used in combination. In addition, the surfactant used may be a commercially available or synthetic product.

Examples of the anionic surfactant include: a sulfonate-based compound such as an alkane sulfonate, an alkyl benzene sulfonate (e.g., a nonyl benzene sulfonate, a decyl benzene sulfonate, a dodecyl benzene sulfonate), a naphthalene sulfonate, an alkyl sulfate (e.g., a lauryl sulfate, an octadecyl sulfate), a polyoxyalkylene sulfate, an α-olefin sulfonate, an α-sulfo fatty acid salt, an α-sulfo fatty acid alkyl ester salt, an alkyl sulfosuccinate, and a dialkyl sulfosuccinate; a sulfuric acid ester compound such as an alkyl sulfuric acid ester salt, an alkenyl sulfuric acid ester salt, a polyoxyalkylene alkyl ether sulfuric acid ester salt (e.g., a polyoxyethylene octadecyl ether sulfate, a polyoxyethylene lauryl ether sulfate), and a polyoxyalkylene alkenyl ether sulfuric acid ester salt; a carboxylic acid-based compound such as an alkyl ether carboxylate, an amide ether carboxylate, a sulfosuccinate, and an amino acid-based surfactant; and a phosphoric acid ester compound such as an alkyl phosphoric acid ester salt and an alkyl ether phosphoric acid ester salt. Among them, a polyoxyalkylene alkyl ether sulfuric acid ester salt is preferred. If the anionic surfactant forms a salt, the salt may be, for example, a metal salt (preferably a monovalent metal salt) such as a sodium salt, a potassium salt, a calcium salt, or a magnesium salt, or an ammonium salt, or an amine salt. One kind of the anionic surfactant may be used singly or two or more kinds thereof may be used in combination.

Examples of the nonionic surfactant include: an oxyalkylene polymer such as polyethylene glycol, polypropylene glycol, and polytetramethylene glycol; a polyoxyalkylene derivative (e.g., a polyoxyalkylene adduct) such as a polyoxyethylene alkyl ether, a polyoxyethylene alkyl phenyl ether, a polyoxyethylene alkyl amine, a polyoxyethylene fatty acid ester, a polyoxyethylene glyceryl ether fatty acid ester, a polyoxyethylene sorbitan fatty acid ester; or a copolymer of multiple oxyalkylenes (e.g., a diblock copolymer, a triblock copolymer, a random copolymer, an alternating copolymer). One kind of the nonionic surfactant may be used singly or two or more kinds thereof may be used in combination.

Examples of the cationic surfactant include: an amine-type cationic surfactant (e.g., an alkylamidoamine, an alkylamine); or a quaternary ammonium salt-type cationic surfactant (e.g., a tetraalkyl (number of carbon atoms: 1 to 4) ammonium salt (e.g., a tetramethylammonium salt), a mono-long-chain alkyl (number of carbon atoms: 8 to 18)/tri-short-chain alkyl (number of carbon atoms: 1 to 2) ammonium salt (e.g., a lauryl trimethyl ammonium salt, a hexadecyl trimethyl ammonium salt, a stearyl trimethyl ammonium salt), a di-long-chain alkyl (number of carbon atoms: 8 to 18)/di-short-chain alkyl (number of carbon atoms: 1 to 2) ammonium salt). If the cationic surfactant forms a salt, the salt may be, for example, a halide (e.g., chlorine, bromine, iodine); a hydroxide; or a sulfonic acid ester, a sulfuric acid ester, or a nitric acid ester having 1 to 5 carbon atoms. Among them, the cationic surfactant is preferably selected from a quaternary ammonium salt-type cationic surfactant (suitably a mono-long-chain alkyl/tri-short-chain alkyl ammonium salt, a di-long-chain alkyl/di-short-chain alkyl ammonium salt). One kind of the cationic surfactant may be used singly or two or more kinds thereof may be used in combination.

The amphoteric surfactant is not particularly limited, and examples thereof include an alkyl betaine-type surfactant, an amino acid-type surfactant, an amine alkylene oxide-type surfactant, or an amine oxide-type surfactant. One kind of the amphoteric surfactant may be used singly or two or more kinds thereof may be used in combination.

The surfactant used in some preferred embodiments may be a compound having a polyoxyalkylene unit. From the viewpoint of further eliciting the above effect, it is more preferable that the surfactant is an anionic surfactant having a polyoxyalkylene unit. The above oxyalkylene unit may be composed of a single oxyalkylene group or may be a structure in which two or more oxyalkylene units are repeated. Examples of the oxyalkylene unit include an oxyethylene unit (EO) or an oxypropylene unit (PO). Among them, the oxyethylene unit (EO) is preferred. When the surfactant has multiple oxyalkylene units, the oxyalkylene units may be of the same type (i.e., one kind) or may contain two or more different oxyalkylene units. The total number of moles of alkylene oxide added contained in the surfactant may be 1 or more, 3 or more, 5 or more, 10 or more, 15 or more, or 20 or more and 50 or less, 30 or less, 22 or less, 16 or less, 12 or less, 8 or less, or 4 or less (e.g., 3 or less).

The surfactant (e.g., an anionic surfactant) used in some embodiments has a hydrocarbon group. The hydrocarbon group may be composed of a saturated hydrocarbon such as an alkyl group or may contain an unsaturated bond such as a carbon-carbon double bond. The hydrocarbon group (typically an alkyl group) may be linear or branched. The number of carbon atoms in the above hydrocarbon group (e.g., alkyl group) may be 8 or more, 10 or more, or 12 or more and 24 or less, 20 or less, 18 or less, 16 or less, or 12 or less. Specific examples of the hydrocarbon group (typically an alkyl group) include an octyl, decyl, lauryl (undecyl), tetradecyl, hexadecyl, or stearyl (octadecyl) group.

The pH of the surfactant (pH of the surfactant at 100% mass concentration, or pH of a surfactant available as a product (which may contain a suitable amount of water, etc.)) is not particularly limited, but is for example, suitably 5.0 or higher, preferably 6.0 or higher (e.g., higher than 6.0), more preferably 6.5 or higher, still more preferably 7.0 or higher, and particularly preferably 7.5 or higher (e.g., higher than 8.0, even 8.2 or higher). The pH of the above surfactant is, for example, suitably less than 11.0, preferably less than 9.5, more preferably 9.0 or less (e.g., less than 9.0), and may be less than 8.0, less than 7.0, less than 6.0, or less than 5.0. High surface quality can be easily achieved by cleaning with a surfactant of a near-neutral range.

Note that as used herein, the pH of a liquid surfactant or a cleaner (typically, a cleaning solution) is determined by using a pH meter (e.g., a glass electrode-type hydrogen ion concentration indicator (model No. F-23) manufactured by HORIBA, Ltd.), by performing a three-point calibration using standard buffers (phthalate pH buffer, pH: 4.01 (25°C); neutral phosphate pH buffer, pH: 6.86 (25°C); and carbonate pH buffer, pH: 10.01 (25°C)), and then by placing a glass electrode in an analytical cleaner to measure a value after two minutes or more have passed and the value is so stabilized.

The concentration (content) of surfactant in the cleaner is appropriately set within the range where the effect of including the surfactant is elicited, and is not limited to a specific range. In some embodiments, the concentration (content) of surfactant in the cleaner may be 0.01 mass% or more, and 0.1 mass% or more is appropriate. In some embodiments, the concentration (content) of surfactant in the cleaner may be 1 mass% or more, 3 mass% or more, 10 mass% or more, 20 mass% or more, 30 mass% or more, or 40 mass% or more. In such embodiments, the upper limit of the concentration (content) of surfactant in the cleaner may be 90 mass% or less, 70 mass% or less, 50 mass% or less, or 35 mass% or less.

That is, in some embodiments, the concentration (content) of surfactant in the cleaner may be 0.01 mass% or more and 90 mass% or less, 0.1 mass% or more and 70 mass% or less, 0.1 mass% or more and 50 mass% or less, 0.1 mass% or more and 35 mass% or less, 0.1 mass% or more and 30 mass% or less, 3 mass% or more and 30 mass% or less, 10 mass% or more and 30 mass% or less, or 20 mass% or more and 30 mass% or less.

When the cleaner contains two or more different surfactants, the concentration (content) of surfactant means the total amount of these surfactants.

### <Solvent (water)>

The solvent of the cleaner as disclosed herein consists of water. The above effects can be better achieved when the solvent consists of water. Such a cleaner may be a cleaning solution that is liquid at room temperature (e.g., 20°C or more and 25°C or less). Suitable water used in the cleaner is, for instance, ion-exchanged water (deionized water), pure water, ultrapure water, or distilled water. Note that the cleaner disclosed herein is free of any organic solvent (e.g., lower alcohol, lower ketone) as a solvent. If the cleaner contains an organic solvent, the uniformity of the cleaner and the safety of the cleaner is deteriorated.

### <Other additives>

The cleaner disclosed herein may further optionally contain one or two or more known additives that may be used in cleaners, such as pH adjusting agents, antifoaming agents, antiseptic agents, and mold inhibitors.

It is also preferred that the cleaner disclosed herein further contains at least one of an inorganic acid or an oxidant. The inorganic acid is thought to lower the pH of the cleaner and increase the solubility of metal ions in the cleaner, thereby further facilitating the removal of metal ion residues on a polished silicon carbide substrate surface. In addition, the oxidant can ionize metal precipitates, etc., that may be present on the silicon carbide surface, and is thought to have the function of further facilitating the removal of residues on the silicon carbide surface.

Examples of the inorganic acid include sulfuric acid, nitric acid, hydrochloric acid, carbonic acid, boric acid, hypophosphorous acid, phosphorous acid, or phosphoric acid. Nitric acid is more preferred.

The oxidant may be selected from among oxidants used in the polishing composition described below. From the viewpoint of decreasing metal ion residues, a metal element-free oxidant is preferred. Examples of the oxidant include hydrogen peroxide, peroxomonosulfuric acid, ammonium peroxo-monosulfate, peroxodisulfuric acid, ammonium peroxodisulfate, peroxophosphoric acid, peroxosulfuric acid, performic acid, peracetic acid, perbenzoic acid, perphthalic acid, hypobromic acid, hypoiodic acid, chloric acid, bromic acid, iodic acid, periodic acid, perchloric acid, or hypochlorous acid. Among these oxidants, hydrogen peroxide is preferred.

One kind each of the above inorganic acids and oxidants may be used singly or two or more kinds thereof may be used in combination.

The concentration (content) of the above other additives may be within an appropriate range that does not significantly interfere with the effects of the present invention. For example, in the case of including the other additives, the upper limit of concentration (content) of the other additives in the cleaner is suitably 10 mass% or less, and may be 5 mass% or less, 3 mass% or less, or 1 mass% or less. The lower limit of concentration (content) of the other additives in the cleaner in the case of including the other additives is more than 0 mass%. Note that the other additives are defined as components different from the chelating agent, the surfactant, and water.

### <pH>

The pH of the cleaner disclosed herein is not particularly limited. For example, the pH of the cleaner may be 0.5 or higher, 1.0 or higher, 1.5 or higher, or 2.0 or higher. The pH of the cleaner may be, for example, less than 7.0, 6.5 or less, 6.0 or less, or 5.0 or less. In some embodiments, the pH of the cleaner is, for example, less than 5.0, preferably less than 4.5, and more preferably 4.0 or less or 3.5 or less. The cleaner in an acidic range may be used for cleaning. This makes it possible to further decrease metal ion residues on the surface of the silicon carbide substrate and particle residues caused by an abrasive, etc., contained in the polishing composition.

### <Cleaning method>

The cleaning method disclosed herein includes a step of cleaning a polished silicon carbide substrate by using a cleaner (cleaning step). The cleaning involves removing an abrasive and a polishing aid from a silicon carbide substrate surface that has been polished using a polishing composition containing the abrasive and the polishing aid. A cleaner used is the above-mentioned cleaner. The cleaning method is not particularly limited and can be implemented by any means appropriate for the purpose. For example, one or two or more cleaning processes selected from immersion cleaning, spray cleaning, scrubbing, ultrasonic cleaning, rinse polishing, etc., may be employed. From the viewpoint of cleaning performance, scrubbing or rinse polishing is preferred. Note that the scrubbing refers to cleaning by wiping or scrubbing the substrate surface with a cleaning tool such as a sponge, brush, or non-woven fabric. For example, a cleaner may be applied to the surface of a cleaning tool such as a sponge, brush, or non-woven fabric, and the cleaning tool with the cleaner may be brought into contact with a substrate surface and relatively moved to remove particles and other adherents attached onto the substrate surface. From the viewpoint of effectively removing adhered particles, it is preferable to conduct the cleaning step before the polished substrate surface dries. Note that the cleaning step disclosed herein may preferably be performed in a manner without ultrasonic cleaning or microwave cleaning.

From the viewpoint of removal of adhered particles, scrubbing with a sponge (e.g., polyvinyl alcohol (PVA) sponge) may be used as a cleaning method. This type of cleaning is also called sponge cleaning. In scrubbing, water (e.g., deionized water, pure water, ultrapure water, distilled water) may or may not be additionally supplied to a substrate surface as needed.

The duration of the cleaning step using the cleaner is not particularly limited, and from the viewpoint of particle removal from the substrate surface, the duration is suitably 10 seconds or longer, preferably 30 seconds or longer, and more preferably 1 minute or longer. From the viewpoint of cleaning efficiency, the duration is suitably about 30 minutes or less, preferably 10 minutes or less, and more preferably 3 minutes or less (e.g., 1 minute or more and 2 minutes or less).

The temperature of the cleaner in the cleaning step may usually be at normal temperature (typically 10°C or more and less than 40°C, e.g., about 20°C or more and 30°C or less). The cleaner may be heated (e.g., heated to about 40°C or higher or 50°C or higher and 80°C or less) to perform the cleaning.

In some preferred embodiments, preliminary cleaning (also called pre-cleaning) is performed before the cleaning step using the above cleaner. The preliminary cleaning may be cleaning without using the above cleaner. For example, one or two or more processes selected from immersion cleaning, running water cleaning, spray cleaning, scrubbing, ultrasonic cleaning, rinse polishing, etc., may be employed. For example, the preliminary cleaning may be immersion in water (e.g., deionized water, pure water, ultrapure water, distilled water; unless otherwise specified, the same applies to the following), cleaning with running water, cleaning by spraying water, scrubbing with water, ultrasonic cleaning in a water tank containing water, rinse polishing with water, etc. The immersion in water may be batch immersion, where a substrate is immersed in a water tank filled with water, overflow immersion, where immersion is performed while water is overflowed into the water tank, or quick dump immersion. From the viewpoint of cleaning performance, scrubbing is preferred. The scrubbing with water is preferably performed while supplying water (running water) to the substrate surface. Scrubbing with a sponge (e.g., PVA sponge) is preferred for scrubbing in the preliminary cleaning. From the viewpoint of effectively removing adhered particles, it is preferable that the preliminary cleaning step is performed before the polished substrate surface dries. It is also preferable that after the preliminary cleaning step, the above cleaning step is performed before the substrate surface dries.

The duration of the preliminary cleaning step is not particularly limited, and from the viewpoint of cleaning performance, the duration is suitably 10 seconds or longer, and preferably 30 seconds or longer. From the viewpoint of cleaning efficiency, the duration is suitably about 10 minutes or less, and preferably 3 minutes or less (e.g., 1 minute or more and 2 minutes or less).

In some embodiments, post-cleaning is performed after the cleaning step using the above cleaner. The post-cleaning may be performed in the same way as in the preliminary cleaning described above, except that the post-cleaning is performed after the cleaning step described above. Duplicate explanations are thus omitted. In the post-cleaning, a method, namely a combination of running water cleaning and immersion cleaning (e.g., overflow immersion) may be preferably employed. If immersion cleaning is employed, the duration of the post-cleaning step is suitably 1 minute or longer, and preferably 10 minutes or longer (e.g., about 10 minutes or more and 30 minutes or less).

The cleaning method disclosed herein can achieve a good cleaning effect on silicon carbide substrates by using a surfactant, and in a preferred embodiment, by scrubbing using a sponge. Therefore, the method, as a whole, can be preferably implemented in a manner that does not include ultrasonic or microwave cleaning, which are commonly used in conventional cleaning methods.

### (Rinse polishing treatment (rinse cleaning))

The cleaner disclosed herein is suitable for use in rinse polishing treatment (rinse cleaning). The rinse polishing treatment is performed on a polishing table (platen) with a polishing pad attached for the purpose of removing residues on the surface of a polished polishing target after final polishing (finish polishing) has been performed on a polishing target to obtain the polished polishing target. At this time, rinse polishing treatment is performed by bringing the cleaner of the present invention into direct contact with the polished polishing target. As a result, residues on the surface of the polished polishing target are removed by the frictional force (physical action) of the polishing pad and the chemical action of the cleaner. Among the residues, particle residues, metal ion residues, metal residues and the like in particular, are easily removed by the physical action. Thus, in the rinse polishing treatment, particle residues and metal ion residues can be effectively removed by using friction with the polishing pad on the polishing table (platen).

Specifically, the rinse polishing treatment is performed by placing a surface of the polished polishing target after the polishing step on the polishing table (platen) of a polishing equipment, bringing the polished polishing target into contact with the polishing pad, and sliding the polishing pad relative to the polished polishing target while supplying the cleaner to the contact area.

There are no particular restrictions on the conditions for the rinse polishing treatment, but for example, the pressure between the polished polishing target and the polishing pad is preferably 0.5 psi (3.45 kPa) or more and 10 psi (68.9 kPa) or less. The head rotation speed is preferably 10 rpm (0.17s⁻¹) or more and 200 rpm (3.33s⁻¹) or less. In addition, the polishing table (platen) rotation speed is preferably 10 rpm (0.17s⁻¹) or more and 200 rpm (3.33s⁻¹) or less. There is no limit on the running water feed rate, but it is preferable that the surface of the polished polishing target is covered with the cleaner. For example, the running water feed rate is 10 ml/min or more and 5000 ml/min or less. The cleaning duration is also not particularly limited, but is preferably 5 seconds or more and 180 seconds or less.

Within this range, residues on the surface of the silicon carbide substrate can be better removed.

The temperature of the cleaner during the rinse polishing treatment is not particularly limited, and is usually room temperature (20°C or more and 25°C or less), but may be heated to about 40°C or more and 70°C or less as long as the performance is not impaired.

The rinse polishing treatment may be performed using either a single-side polishing equipment or a double-side polishing equipment. In addition to a nozzle for discharging the polishing composition, it is preferable that the above polishing equipment is equipped with a nozzle for discharging the cleaner. The operating conditions during the rinse cleaning treatment by the polishing equipment are not particularly limited, and may be set appropriately by a person skilled in the art.

An amount of metal ions remaining on the surface of the silicon carbide substrate cleaned as described above is very small. The amount of the metal ions is not particularly limited, but may be 1 × 10¹³ atoms/cm² or less in the case of aluminum ions as an example. The amount of the metal ions is measured by X-ray fluorescence spectrometry (XRF) as described in the Examples below.

The cleaned silicon carbide substrates, after being dried naturally or being forced drying using a dryer, are preferably used as semiconductor substrate materials for various device applications (e.g., optical devices, power devices).

### [Method for producing substrate]

There is also herein provided a method for producing a silicon carbide substrate, the method including the above cleaning method. The technology disclosed herein may involve: a method for producing a silicon carbide substrate; and providing a silicon carbide substrate produced by the method. In other words, the technology disclosed herein provides: a method for producing a silicon carbide substrate, the method including a cleaning step of cleaning a silicon carbide substrate by supplying any cleaner disclosed herein to the silicon carbide substrate; and a silicon carbide substrate produced by the method. The above production method may be implemented by preferably applying the contents of any of the cleaning methods disclosed herein. The above production method can efficiently provide a clean silicon carbide substrate with improved surface quality.

In addition, the method for producing a silicon carbide substrate may also include a step (polishing step) of polishing a silicon carbide substrate to be polished before the above cleaning step. The polishing step described above is specifically a step of polishing a surface of a silicon carbide substrate by using the polishing composition described below. The cleaner and cleaning method disclosed herein can suitably achieve the desired effect when applied to a polished silicon carbide substrate that has undergone the polishing step described below. The cleaner and cleaning method disclosed herein are preferably implemented in combination with polishing as described below. Thus, there is herein provided a method of polishing and cleaning a silicon carbide substrate. The following will describe a polishing composition and polishing method used for polishing a silicon carbide substrate.

### [Polishing composition]

### <Abrasive >

The polishing composition disclosed herein typically contains an abrasive. It is preferable that the polishing composition contains an abrasive from the viewpoint of efficiently achieving excellent smoothness. There are no particular limitations on the type of the abrasive that may be included in the polishing composition. For example, the abrasive may be any of inorganic particles, organic particles, or organic-inorganic composite particles. Examples include the abrasive substantially composed of any of the following: oxide particles (e.g., silica particles, alumina particles, cerium oxide particles, chromium oxide particles, titanium dioxide particles, zirconium oxide particles, magnesium oxide particles, manganese dioxide particles, zinc oxide particles, iron oxide particles); nitride particles (e.g., silicon nitride particles, boron nitride particles); carbide particles (e.g., silicon carbide particles, boron carbide particles); diamond particles; or carbonates (e.g., calcium carbonate, barium carbonate). One kind of the abrasive may be used singly or two or more kinds thereof may be used in combination. Among them, oxide particles (e.g., silica particles, alumina particles, cerium oxide particles, chromium oxide particles, zirconium oxide particles, manganese dioxide particles, iron oxide particles) are preferred because they can form favorable surfaces. In some embodiments, alumina particles, zirconium oxide particles, chromium oxide particles, or iron oxide particles are more preferred, and alumina particles are particularly preferred. In some other embodiments, silica particles, cerium oxide particles, or manganese dioxide particles are more preferred, and silica particles are particularly preferred.

Note that as used herein, the wording "substantially consisting of X" or "substantially composed of X" with respect to the composition of the abrasive means that the percentage of X in the abrasive (purity of X) is 90% or more (preferably 95% or more, more preferably 97% or more, still more preferably 98% or more, for example, 99% or more) on a mass basis.

In some embodiments, alumina particles are used as the abrasive. One kind of the alumina particles may be used singly or two or more kinds thereof may be used in combination. When alumina particles are used as the abrasive, it is generally advantageous to have a higher percentage of alumina particles to the total abrasive contained in the polishing composition. For example, the percentage of alumina particles to the total abrasive contained in the polishing composition is preferably 70 mass% or more, more preferably 90 mass% or more, and still more preferably 95 mass% or more (e.g., 95 mass% or more and 100% or less).

In some preferred embodiments, silica particles are used as the abrasive. Examples of the silica particles include colloidal silica, fumed silica, or precipitated silica. From the viewpoint of improving smoothness, colloidal silica and fumed silica are preferred silica particles. Among them, colloidal silica is particularly preferred. The technology disclosed herein is suitable for the method involving polishing using a polishing composition containing silica particles. When silica particles adhere to a silicon carbide substrate surface during polishing of the silicon carbide substrate with silica particles, their removal is often not as easy as with other particles. The technology disclosed herein enables silica particles adhered to such a substrate surface to be preferably removed using the cleaner described above. One kind of the silica particles may be used singly or two or more kinds thereof may be used in combination.

When silica particles are used as the abrasive, it is generally advantageous to have a higher percentage of silica particles to the total abrasive contained in the polishing composition. For example, the percentage of silica particles to the total abrasive contained in the polishing composition is preferably 70 mass% or more, more preferably 90 mass% or more, and still more preferably 95 mass% or more (e.g., 95 mass% or more and 100% or less).

The polishing composition disclosed herein can also use a non-diamond abrasive substantially free of diamond particles as the abrasive. The high hardness of diamond particles may be a limiting factor in improving smoothness. In addition, since diamond particles are generally expensive, they are not a cost-effective material, and from a practical standpoint, it is desirable to have less reliance on high-priced materials such as diamond particles.

The average primary particle size of the abrasive (e.g. silica particles) is not particularly limited, and from the viewpoint of improving the polishing removal rate, it can be 10 nm or more, more preferably 15 nm or more, and still more preferably 20 nm or more, 50 nm or more, or 60 nm or more. By increasing the average primary particle size, a higher polishing removal rate can be achieved. In addition, from the viewpoint of surface quality after polishing, the average primary particle size above is usually 500 nm or less, and suitably 300 nm or less, preferably 150 nm or less, more preferably 100 nm or less, and still more preferably 80 nm or less, and for examples, it may be 60 nm or less.

Note that in the technology disclosed herein, the average primary particle size of the abrasive refers to the particle size (BET particle size) calculated from the specific surface area (BET value) measured by the BET method using the formula: Average primary particle size (nm) = 6000/(True density (g/cm³) × BET value (m²/g)). The specific surface area may be measured, for example, using a surface area meter (trade name: "Flow Sorb II2300", manufactured by Micromeritics Instrument Corporation).

When the polishing composition contains the abrasive, the concentration (content) of the abrasive in the polishing composition is usually appropriate to be 0.01 mass% or more from the viewpoint of the polishing removal rate, and may be 0.1 mass% or more, 1 mass% or more, or 3 mass% or more. From the viewpoint of efficiently improving smoothness, the concentration (content) of the abrasive above is preferably 10 mass% or more, and more preferably 20 mass% or more. In addition, from the viewpoint of obtaining good dispersibility, the concentration (content) of the abrasive in the polishing composition is usually appropriate to be 50 mass% or less, preferably 40 mass% or less, and may be 20 mass% or less, 10 mass% or less, or 8 mass% or less. In some other embodiments, from the viewpoint of obtaining the desired surface quality, the polishing composition may be free of the abrasive.

### <Polishing aid>

The polishing composition disclosed herein preferably contains a polishing aid. The polishing aid is a component that enhances the effect of polishing and typically water-soluble one is used. The polishing aid is not to be interpreted in a particularly limited way, but is thought to contribute to polishing with the abrasive by exerting an effect of modifying (typically oxidative modification) the surface of a silicon carbide substrate during polishing and causing a surface of the substrate to become brittle. Specifically, during polishing of a silicon carbide substrate, the polishing aid is thought to contribute to the oxidation of silicon carbide, i.e., conversion to SiOₓC_{y}. The SiOₓC_{y} has a lower hardness than silicon carbide single crystal. Therefore, it is considered that the addition of a polishing aid improves the polishing removal rate and the surface quality of the silicon carbide substrate can be improved.

Thus, according to a preferred embodiment, the above polishing composition contains an abrasive and a polishing aid. The abrasive may be a non-diamond abrasive.

Examples of the polishing aid used in the polishing composition include an oxidant and a metal salt, but are not particularly limited thereto.

### (Oxidant)

The oxidant is effective in reducing the hardness of a non-oxide material with high hardness, such as silicon carbide, and making the material brittle. Therefore, the oxidant can elicit an effect of increasing the polishing removal rate during polishing of silicon carbide. The oxidant herein does not include a metal salt as described below. Examples of the oxidant include peroxides (e.g., hydrogen peroxide); persulfuric acid compounds (e.g., potassium peroxomonosulfate, persulfuric acid (peroxo disulfuric acid) or its salt (e.g., ammonium persulfate, potassium persulfate)); chlorine compounds (e.g., chloric acid or its salt, perchloric acid or its salt (e.g., potassium perchlorate)); bromine compounds (e.g., bromic acid or its salt (e.g., potassium bromate)); iodine compounds (e.g., iodic acid or its salt (e.g., ammonium iodate), periodic acid or its salt (e.g., sodium periodate, potassium periodate)); iron acids (e.g., ferric acid or its salt (e.g., potassium ferrate)); permanganic acids (e.g., permanganic acid or its salt (e.g., sodium permanganate, potassium permanganate)); chromic acids (e.g., chromic acid or its salt (e.g., potassium chromate, potassium dichromate)); vanadic acids (e.g., vanadic acid or its salt (e.g., ammonium vanadate, sodium vanadate, potassium vanadate)); ruthenic acids (e.g., perruthenic acid or its salt); molybdic acids (e.g., molybdic acid or its salt (e.g., ammonium molybdate and disodium molybdate)); perrhenic acids (e.g., perrhenic acid or its salt); and tungstic acids (e.g., tungstic acid or its salt (e.g., disodium tungstate)). One kind of these oxidants may be used singly or two or more kinds thereof may be used in combination appropriately. In some embodiments, as the oxidant, permanganic acid or its salt, chromic acid or its salt, or ferric acid or its salt is preferred, and sodium permanganate or potassium permanganate is particularly preferred. In some other embodiments, as the oxidant, vanadic acid or its salts, iodine compounds, molybdic acid or its salts, tungstic acid or its salts are preferred, and sodium metavanadate, sodium vanadate, or potassium vanadate is particularly preferred.

In some preferred embodiments, the polishing composition contains a composite metal oxide as the oxidant. Examples of the composite metal oxide include metal nitrates, iron acids, permanganic acids, chromic acids, vanadic acids, ruthenic acids, molybdic acids, perrhenic acids, or tungstic acids. Among them, iron acids, permanganic acids, chromic acids, vanadic acids, molybdic acids, or tungstic acids are more preferred, and permanganic acids or vanadic acids are still more preferred.

The polishing composition disclosed herein may or may not further contain an oxidant other than the composite metal oxides described above. The technology disclosed herein can preferably be implemented in a manner that includes the above composite metal oxide, as an oxidant, and an oxidant (e.g., hydrogen peroxide) other than the above composite metal oxide. In addition, the technology disclosed herein may be implemented in a manner that is substantially free of an oxidant (e.g., hydrogen peroxide) other than the above composite metal oxide as the oxidant.

The concentration (content) of oxidant in the polishing composition is usually appropriate to be 0.005 mol/L or more. From the viewpoint of improving the polishing removal rate, the concentration (content) of oxidant in the polishing composition is preferably 0.008 mol/L or more and more preferably 0.01 mol/L or more, and may be 0.03 mol/L or more, 0.05 mol/L or more, 0.06 mol/L or more, or 0.07 mol/L or more. In some embodiments, the concentration of oxidant may be 0.12 mol/L or more, 0.14 mol/L or more, or 0.16 mol/L or more from the viewpoint of facilitating a higher polishing removal rate. From the viewpoint of improving smoothness, the concentration (content) of oxidant in the polishing composition is usually appropriate to be 2.5 mol/L or less, and is preferably 2.0 mol/L or less and more preferably 1.7 mol/L or less. The concentration (content) of oxidant in the polishing composition may be 1.5 mol/L or less, 1.0 mol/L or less, 0.75 mol/L or less, 0.5 mol/L or less, 0.4 mol/L or less, or 0.3 mol/L or less. When the polishing composition contains two or more different oxidants, the concentration (content) of oxidant means the total amount of these oxidants.

### (Metal salt)

The polishing composition disclosed herein may contain a metal salt different from the oxidant as a polishing aid. The use of the above metal salt is more likely to increase the polishing removal rate. In addition, the use of the above metal salt is likely to suppress deterioration of the performance of the polishing composition (e.g., a decrease in the polishing removal rate). The above metal salt may be selected from one or more kinds of the below-described metal salt A, metal salt B, and metal salt C.

### (Metal salt A)

In some preferred embodiments, the polishing composition contains a metal salt A selected from alkaline earth metal salts. As the metal salt A, one kind of alkaline earth metal salt may be used singly or two or more kinds thereof may be used in combination. The use of the metal salt A may increase the polishing removal rate. The metal salt A preferably contains, as an element belonging to alkaline earth metals, one or two or more of Mg, Ca, Sr, and Ba. Among them, any one of Ca and Sr is preferred, and Ca is more preferred.

The type of salt in the metal salt A is not particularly limited and may be an inorganic acid salt or an organic acid salt. Examples of the inorganic acid salt include a salt of a hydrohalic acid (e.g., hydrochloric acid, hydrobromic acid, hydrofluoric acid) or a salt of nitric acid, sulfuric acid, carbonic acid, silicic acid, boric acid, or phosphoric acid. Examples of the organic acid salt include: a salt of a carboxylic acid (e.g., formic acid, acetic acid, propionic acid, benzoic acid, glycic acid, butyric acid, citric acid, tartaric acid, trifluoroacetic acid); a salt of an organic sulfonic acid (e.g., methanesulfonic acid, trifluoromethanesulfonic acid, benzenesulfonic acid, toluenesulfonic acid); a salt of an organic phosphonic acid (e.g., methyl phosphonic acid, benzene phosphonic acid, toluene phosphonic acid); or a salt of an organic phosphoric acid (e.g., ethyl phosphoric acid). Among them, a salt of hydrochloric acid, nitric acid, sulfuric acid, or phosphoric acid is preferred, and a salt of hydrochloric acid or nitric acid is more preferred. The technology disclosed herein may be preferably implemented, for example, in a manner using, as the metal salt A, a nitrate or chloride of alkaline earth metal.

Examples of the alkaline earth metal salt that can be an option for the metal salt A include a chloride (e.g., magnesium chloride, calcium chloride, strontium chloride, barium chloride); a bromide (e.g., magnesium bromide, calcium bromide, strontium bromide, barium bromide); a fluoride (e.g., magnesium fluoride, calcium fluoride, strontium fluoride, barium fluoride); a nitrate (e.g., magnesium nitrate, calcium nitrate, strontium nitrate, barium nitrate); a sulfate (e.g., magnesium sulfate, calcium sulfate, strontium sulfate, barium sulfate); a carbonate (e.g., magnesium carbonate, calcium carbonate, strontium carbonate, barium carbonate); or a carboxylate (e.g., magnesium acetate, calcium acetate, strontium acetate, barium acetate, magnesium benzoate, calcium benzoate, barium benzoate, magnesium citrate, calcium citrate, strontium citrate, barium citrate).

The metal salt A is preferably a water-soluble salt. The water-soluble metal salt A may be used to efficiently form a favorable surface with few defects such as scratches.

In addition, the metal salt A is preferably a compound that is not oxidized by the oxidant. By appropriately selecting the oxidant and the metal salt A from this perspective, it is possible to prevent deactivation of the oxidant due to oxidation of the metal salt A by the oxidant and suppress deterioration of the performance of the polishing composition over time (e.g., a decrease in the polishing removal rate). From this perspective, preferable examples of the metal salt A include calcium nitrate.

When the polishing composition contains the metal salt A, the concentration (content) of the metal salt A in the polishing composition is not particularly limited and may be appropriately set to achieve the desired effect depending on the purpose of use and mode of use of the polishing composition. The concentration of the metal salt A may be, for example, approximately 1000 mM or less (i.e., 1 mol/L or less), 500 mM or less, or 300 mM or less. In some embodiments, the concentration of the metal salt A is appropriate to be 200 mM or less, and is preferably 100 mM or less, more preferably 50 mM or less, and may be 30 mM or less, 20 mM or less, or 10 mM or less. The lower limit of the concentration of the metal salt A may be, for example, 0.1 mM or more, and from the viewpoint of properly producing the effect of using the metal salt A, is preferably 0.5 mM or more, more preferably 1 mM or more, and may be 2.5 mM or more, 5 mM or more, 10 mM or more, 20 mM or more, or 30 mM or more.

### (Metal salt B)

In some preferred embodiments, the polishing composition contains a metal salt B selected from salts of a cation containing a metal belonging to Groups 3 to 16 of the periodic table and an anion. As the metal salt B, one kind of metal salt selected from salts of a cation containing a metal belonging to Groups 3 to 16 of the periodic table and an anion may be used singly or two or more kinds thereof may be used in combination. The use of the metal salt B may increase the polishing removal rate.

The cation of metal salt B may be cation containing a transition metal, i.e., a metal belonging to Groups 3 to 12 of the periodic table, or a cation containing a poor metal, i.e., a metal belonging to Groups 13 to 16. As the above transition metal, those belonging to Groups 4 to 11 of the periodic table are preferred. In addition, those belonging to Periods 4 to 6 of the periodic table are appropriate, those belonging to Periods 4 to 5 are preferred, and those belonging to Period 4 are more preferred. As the above poor metal, those belonging to Groups 13 to 15 of the periodic table are preferred, those belonging to Groups 13 to 14 are more preferred, in addition, those belonging to Periods 3 to 5 of the periodic table are preferred, those belonging to Periods 3 to 4 are more preferred, and the poor metal belonging to Period 3, namely aluminum, is particularly preferred.

In some embodiments, the metal salt B is preferably a salt of a cation containing a metal of which a hydrated metal ion has a pKa of approximately less than 7 and an anion. The metal salt B, which is a salt of such a cation and an anion, generates a hydrated metal cation in water. The hydrated metal cation acts as a pH buffer because protons on coordination water are in adsorption-desorption equilibrium, and thus tends to suppress deterioration of the performance of the polishing composition over time. From this viewpoint, the metal salt B adopted may be preferably a salt of a metal cation of which a hydrated metal ion has a pKa of, for example, less than 7.0 or 6.0 or less and an anion. Examples of the metal cation of which a hydrated metal ion has a pKa of 6.0 or less, include, but are not limited to, Al³⁺ (the hydrated metal ion has a pKa of 5.0), Cr³⁺ (the pKa: 4.0), Fe³⁺ (the pKa: 2.2), ZrO²⁺ (the pKa: -0.3), Ga³⁺ (the pKa: 2.6), or In³⁺ (the pKa: 4.0).

The type of salt for the metal salt B is not particularly limited and may be an inorganic acid salt or an organic acid salt. Examples of the inorganic acid salt include a salt of a hydrohalic acid (e.g., hydrochloric acid, hydrobromic acid, hydrofluoric acid) or a salt of nitric acid, sulfuric acid, carbonic acid, silicic acid, boric acid, or phosphoric acid. Examples of the organic acid salt include: a salt of a carboxylic acid (e.g., formic acid, acetic acid, propionic acid, benzoic acid, glycic acid, butyric acid, citric acid, tartaric acid, trifluoroacetic acid); a salt of an organic sulfonic acid (e.g., methanesulfonic acid, trifluoromethanesulfonic acid, benzenesulfonic acid, toluenesulfonic acid); a salt of an organic phosphonic acid (e.g., methyl phosphonic acid, benzene phosphonic acid, toluene phosphonic acid); or a salt of an organic phosphoric acid (e.g., ethyl phosphoric acid). Among them, a salt of hydrochloric acid, nitric acid, sulfuric acid, or phosphoric acid is preferred, and a salt of hydrochloric acid, nitric acid, or sulfuric acid is more preferred. The technology disclosed herein can be preferably implemented, for example, in a manner using, as the metal salt B, a salt of a cation, which is one of Al³⁺, Cr³⁺, Fe³⁺, ZrO²⁺, Ga³⁺, or In³⁺ with a nitrate ion (NO³⁻) or a chloride ion (Cl⁻).

The metal salt B is preferably a water-soluble salt. The water-soluble metal salt B may be used to efficiently form a favorable surface with few defects such as scratches.

In addition, the metal salt B is preferably a compound that is not oxidized by the oxidant. By appropriately selecting the oxidant and the metal salt B from this perspective, it is possible to prevent deactivation of the oxidant due to oxidation of the metal salt B by the oxidant, and suppress deterioration of the performance of the polishing composition over time (e.g., a decrease in the polishing removal rate). From this viewpoint, preferable examples of the metal salt B include aluminum nitrate or aluminum chloride.

When the polishing composition contains the metal salt B, the concentration (content) of the metal salt B in the polishing composition is not particularly limited and may be appropriately set to achieve the desired effect depending on the purpose of use and mode of use of the polishing composition. The concentration of the metal salt B may be, for example, approximately 1000 mM or less (i.e., 1 mol/L or less), 500 mM or less, or 300 mM or less. In some embodiments, the concentration of the metal salt B is appropriate to be 200 mM or less, and is preferably 100 mM or less, more preferably 50 mM or less, and may be 40 mM or less, 35 mM or less, or 32 mM or less. The lower limit of the concentration of the metal salt B may be, for example, 0.1 mM or more, and from the viewpoint of properly producing the effect of using the metal salt B, is advantageously 1 mM or more, preferably 5 mM or more, and more preferably 10 mM or more (e.g., 15 mM or more), and may be 20 mM or more or 25 mM or more.

### (Metal salt C)

In some preferred embodiments, the polishing composition contains a metal salt C selected from salts of a cation containing a metal belonging to transition metals, namely Groups 3 to 12 of the periodic table and an anion. One kind of the metal salt C may be used singly or two or more kinds thereof may be used in combination. In the polishing composition containing an oxidant, the metal salt C may be used. This can suppress deterioration of the performance of the polishing composition (e.g., a decrease in the polishing removal rate) due to pH fluctuation of the polishing composition during polishing of a polishing target.

As the transition metal, those belonging to Groups 4 to 11 of the periodic table are preferred, those belonging to Periods 4 to 6 of the periodic table are suitable, those belonging to Periods 4 to 5 are preferred, and those belonging to Period 4 are more preferred.

In some embodiments, the metal salt C is preferably a salt of a cation containing a metal of which a hydrated metal ion has a pKa of approximately lower than 7 and an anion. The metal salt C, which is a salt of such a cation and an anion, forms a hydrated metal cation in water. The hydrated metal cation acts as a pH buffer because protons on coordinating water are in adsorption-desorption equilibrium, and thus tends to suppress deterioration of the performance of the polishing composition over time. From this viewpoint, the metal salt C adopted may be preferably a salt of a cation containing a metal of which a hydrated metal ion has a pKa of, for example, lower than 7.0 or 6.0 or less and an anion. Examples of the cation of a metal of which a hydrated metal ion has a pKa of 6 or less, include, but are not limited to, Cr³⁺ (the hydrated metal ion has a pKa of 4.2), Fe³⁺ (the hydrated metal ion has a pKa of 2.2), Hf⁴⁺ (the hydrated metal ion has a pKa of 0.2), Zr⁴⁺ (the hydrated metal ion has a pKa of -0.3), or Ti⁴⁺ (the hydrated metal ion has a pKa of -4.0).

Examples of the cation constituting the metal salt C include, but are not limited to, cations such as a single-atom transition metal cation (e.g., Cr³⁺, Fe³⁺, Hf⁴⁺, Zr⁴⁺, Ti⁴⁺); an oxy transition metal cation (e.g., ZrO²⁺, ZrO⁺, HfO⁺, TiO⁺, TiO²⁺); or a transition metal hydroxide cation (e.g., ZrOH⁺, HfOH⁺).

The type of salt in metal salt C is not particularly limited, and may be an inorganic salt or an organic salt. Examples of the inorganic salt include a compound such as a salt of an inorganic acid such as a hydrohalic acid (e.g., hydrochloric acid, hydrobromic acid, hydrofluoric acid), nitric acid, sulfuric acid, carbonic acid, silicic acid, boric acid, or phosphoric acid; a sulfide; an oxide; an oxyhalide (e.g., an oxychloride, oxybromide, oxyfluoride); an oxy inorganic acid salt (e.g., an oxynitrate, oxysulfate, oxycarbonate, oxysilicate, oxyborate, oxyphosphate); or an oxysulfide. Examples of the organic salt include a salt of an organic acid such as a salt of a carboxylic acid (e.g., formic acid, acetic acid, propionic acid, benzoic acid, glycic acid, butyric acid, citric acid, tartaric acid, trifluoroacetic acid); a salt of an organic sulfonic acid (e.g., methanesulfonic acid, trifluoromethanesulfonic acid, benzenesulfonic acid, toluenesulfonic acid); a salt of an organic phosphonic acid (e.g., methyl phosphonic acid, benzene phosphonic acid, toluene phosphonic acid); a salt of an organic phosphoric acid (e.g., ethyl phosphoric acid); or an oxyorganic acid salt such as an oxyacetate. Among them, a salt of hydrochloric acid, nitric acid, sulfuric acid, or phosphoric acid is preferred, and a salt of hydrochloric acid or nitric acid is more preferred. The technology disclosed herein can be preferably implemented in the form of an oxy transition metal salt, which is a salt of an oxy transition metal cation and an anion, for example, as the metal salt C. In some preferred embodiments, it can be preferably implemented in the form using a salt of an oxy transition metal cation, which is one of ZrO²⁺, ZrO⁺, HfO⁺, TiO⁺, or TiO²⁺, and nitrate ion (NO₃⁻), sulfate ion (SO₄²⁻), or chloride ion (Cl⁻).

The metal salt C, when dissolved in a solvent, forms a polynuclear transition metal complex composed of the transition metal and oxygen atom(s) and/or hydrogen. For example, when the metal salt C such as zirconyl nitrate, zirconium sulfate, or zirconium chloride is dissolved in water, a polynuclear transition metal complex composed of zirconium and oxygen atom(s) and/or hydrogen is formed. In the technology disclosed herein, the metal salt C can also be preferably implemented in the form of a polynuclear transition metal complex composed of the transition metal and oxygen atom(s) and/or hydrogen formed by dissolving the metal salt C in a solvent. Preferable examples of the polynuclear transition metal complex include a polynuclear transition metal complex composed of zirconium and oxygen atom(s) and/or hydrogen.

The metal salt C is preferably a compound that is not oxidized by the oxidant. By appropriately selecting the oxidant and the metal salt C from this perspective, it is possible to prevent deactivation of the oxidant due to oxidation of the metal salt C by the oxidant, andsuppress deterioration of the performance of the polishing composition over time (e.g., a decrease in the polishing removal rate). From this perspective, preferable examples of the metal salt C include zirconyl nitrate.

When the polishing composition contains the metal salt C, the concentration (content) of the metal salt C in the polishing composition is not particularly limited and may be appropriately set to achieve the desired effect depending on the purpose of use and mode of use of the polishing composition. The concentration of the metal salt C may be, for example, approximately 1000 mM or less (i.e., 1 mol/L or less), 500 mM or less, or 300 mM or less. In some embodiments, the concentration of the metal salt C is appropriate to be 200 mM or less, and is preferably 100 mM or less, more preferably 50 mM or less, and may be 30 mM or less, 20 mM or less, or 10 mM or less. When the polishing composition contains the metal salt C, the lower limit of the concentration of the metal salt C may be, for example, 0.1 mM or more, and from the viewpoint of properly producing the effect of using the metal salt C, is advantageously 1 mM or more, preferably 5 mM or more, and more preferably 10 mM or more (e.g., 15 mM or more), and may be 18 mM or more, 20 mM or more, or 30 mM or more.

### <Additional components>

The polishing compositions disclosed herein may optionally contain known additives that can be used in the polishing composition (a composition for polishing a silicon carbide substrate), such as a chelating agent, a thickener, a dispersing agent, a pH adjusting agent, a surfactant, an inorganic polymer, an organic polymer, an organic acid, an inorganic acid, a rust inhibitor, an antiseptic agent, and an antifungal agent. The concentration (content) of each additive above can be set appropriately, according to the purpose of their addition, and since they do not characterize the present invention, a detailed description is omitted.

### <Dispersing medium>

The dispersing medium used in the polishing composition is not particularly limited as long as the abrasive can be dispersed. Ion-exchanged water (deionized water), pure water, ultrapure water, distilled water, etc., may be preferably used as the dispersing medium. The polishing composition disclosed herein may, if necessary, further contain an organic solvent (e.g., a lower alcohol, a lower ketone) that can be homogeneously mixed with water. Normally, it is preferable that 90 vol% or more of the dispersing medium contained in the polishing composition is water, and it is more preferable that 95 vol% or more (typically 99 vol% or more and 100 vol% or less) is water.

The pH of the polishing composition is not particularly limited. Usually, it is appropriate to set the pH of the polishing composition to 2 or more and 12 or less. When the pH of the polishing composition is within the above range, a practical polishing removal rate is easily achieved. The pH of the polishing composition is preferably 2 or more and 10 or less, more preferably 3 or more and 9.5 or less, and may be 4 or more and 8 or less. In some embodiments, the pH of the polishing composition may be, for example, 6 or more and 10 or less, or 8.5 or more and 9.5 or less.

The method of preparing the polishing composition disclosed herein is not particularly limited. For example, each component in the polishing composition may be mixed using a well-known mixer such as a blade type stirrer, ultrasonic disperser, homo mixer, etc. The way of mixing these components is not limited, for example, all the components may be mixed at once or may be mixed in an appropriately set order.

The polishing compositions disclosed herein may be a one-component type or a multiple-component type, including two-component type. For example, the polishing composition may be configured such that a Liquid A, which contains some of the components constituting the polishing composition, and a Liquid B, which contains the remaining components, are stored separately, and the Liquid A and the Liquid B are mixed and used when a substrate is polished.

The polishing composition disclosed herein may be in a concentrated form (i.e., in the form of a concentrate of polishing liquid) before being used for polishing. This concentrated form of the polishing composition is advantageous in terms of convenience and cost reduction during manufacturing, distribution, storage, etc.

### [Set containing polishing composition and cleaner]

From the above, there is herein provided a set containing a polishing composition and a cleaner used for polishing and cleaning a silicon carbide substrate. This set contains a polishing composition and a cleaner. The above polishing composition is used for polishing a silicon carbide substrate, and the above cleaner is used for cleaning the silicon carbide substrate after polishing with the above polishing composition. The above set is more specifically used for the method for producing a silicon carbide substrate. The above polishing composition disclosed herein is used as a polishing composition. The above-mentioned cleaner disclosed herein is used as a cleaner. Specifically, the above polishing composition may contain, for example, a polishing aid. In addition, the above polishing composition may include, for example, an abrasive. Further, the above cleaner contains a chelating agent, a surfactant, and a solvent, and the solvent consists of water. The above polishing composition and the above cleaner are typically stored separately from each other. The substrate produced using the above set may have high surface quality and clean surfaces after polishing and cleaning. The details of the polishing composition and cleaner are as described above, so their description is omitted.

### [Polishing method]

The polishing composition disclosed herein may be used when a silicon carbide substrate is polished in a manner including, for example, the following operations. That is, a polishing liquid (slurry) containing any of the polishing composition disclosed herein is prepared. Preparing the above polishing liquid includes preparing the polishing liquid by adjusting the concentration of the polishing composition (e.g., diluting the polishing composition), adjusting the pH of the polishing composition, and the like. Alternatively, the above polishing composition may be used as it is as the polishing liquid. In the case of a multi-component type polishing composition, preparing the above polishing liquid may include mixing the components, diluting one or more components before the mixing, diluting the mixture after the mixing, and the like. The polishing liquid is then supplied to a surface to be polished, and the surface is polished using a usual method conducted by a person skilled in the art. For example, the method includes: setting a silicon carbide substrate on a common polishing equipment and supplying the above polishing liquid to a surface of the silicon carbide substrate to be polished through a polishing pad of the polishing equipment. Typically, while the above polishing liquid is continuously supplied, the polishing pad is pressed against the surface of the silicon carbide substrate to be polished and both are moved (e.g., rotation movement) relatively. After the polishing step, the polishing of the silicon carbide substrate is completed.

There is herein provided a polishing method of polishing a silicon carbide substrate and a method for producing a silicon carbide substrate by using the polishing method. The above polishing method is characterized by including the step of polishing a silicon carbide substrate by using the polishing composition disclosed herein. The polishing method according to some preferred embodiments includes a step of performing preliminary polishing (preliminary polishing step) and a step of performing finish polishing (finish polishing step). In some preferred embodiments, the preliminary polishing step is a polishing step arranged immediately before the finish polishing step. The preliminary polishing step may be a single-step polishing process or a multi-step (two or more-step) polishing process. In addition, the finish polishing step herein refers to a step of performing finish polishing against the substrate, on which the preliminary polishing has been conducted, namely a polishing step that is performed the last (i.e., most downstream) of the polishing steps using a polishing slurry containing an abrasive. In this way, in the polishing method including a preliminary polishing step and a finish polishing step, the polishing composition disclosed herein may be used in one sub-step of the preliminary polishing step, in the finish polishing step, or in both the preliminary polishing step and the finish polishing step.

The preliminary polishing and finish polishing may be performed by either a single-side polishing equipment or a double-side polishing equipment. In the single-side polishing equipment, a silicon carbide substrate is attached to a ceramic plate with wax, the silicon carbide substrate is held by a retainer called a carrier, and while a polishing composition is supplied, a polishing pad is pressed against one side of the silicon carbide substrate and both are moved relatively to polish the one side of the silicon carbide substrate. The above movement is, for example, rotational movement. In the double-side polishing equipment, a silicon carbide substrate is held by a retainer called a carrier, and while the polishing composition is supplied from above, polishing pads are pressed against opposing sides of the silicon carbide substrate, and these are rotated in relative directions to simultaneously polish both sides of the silicon carbide substrate.

The polishing pad used in each of the polishing steps disclosed herein is not particularly limited. For example, any of a non-woven fabric type, a suede type, or a hard foamed polyurethane type, or those containing an abrasive or those without an abrasive, etc., may be used. In some embodiments, a non-woven fabric type or a hard foamed polyurethane type polishing pad without an abrasive may be preferably employed.

The silicon carbide substrate polished by the method disclosed herein is typically cleaned after polishing. The above cleaning step involves the cleaning method disclosed herein (a cleaning method using a cleaner containing a chelating agent, a surfactant, and water).

Note that the polishing method disclosed herein may include any other step in addition to the above-mentioned preliminary polishing step and finish polishing step. Examples of such a step include a mechanical polishing step and a lapping step performed before the preliminary polishing step. In the above mechanical polishing step, the silicon carbide substrate is polished using a liquid having a diamond abrasive dispersed in a solvent. In some preferred embodiments, the above dispersion liquid is free of an oxidant. In the above lapping step, a surface of a polishing table, e.g., cast iron table, is pressed against the silicon carbide substrate. Thus, no polishing pad is used in the lapping step. The lapping step is typically performed by supplying an abrasive between the polishing table and the silicon carbide substrate. The abrasive above are typically a diamond abrasive. In addition, the polishing method disclosed herein may also include an additional step before the preliminary polishing step or between the preliminary polishing step and the finish polishing step.

Although embodiments of the present invention have been described in detail, it is clear that this is illustrative and exemplary, not limiting, and that the scope of the present invention should be interpreted by the appended Claims.

The present invention encompasses the following items and forms.
1. A method of polishing and cleaning a silicon carbide substrate, the method comprising the steps of: supplying a polishing composition to a silicon carbide substrate and polishing the silicon carbide substrate; and cleaning the polished silicon carbide substrate by using a cleaner, wherein the cleaner contains a chelating agent, a surfactant, and a solvent, and wherein the solvent consists of water.
2. The method according to item 1, wherein the chelating agent contains a hydroxy acid.
3. The method according to item 1 or 2, wherein the surfactant contains an anionic surfactant having a polyoxyalkylene unit.
4. The method according to any one of items 1 to 3, wherein the cleaner further contains at least one of an inorganic acid or an oxidant.
5. The method according to any one of items 1 to 4, wherein the cleaner has a pH of less than 7.0.
6. The method according to any one of items 1 to 5, wherein the polishing composition contains an abrasive and a polishing aid.
7. The method according to item 6, wherein the abrasive contains a non-diamond abrasive.
8. A cleaner for use in the method according to any one of items 1 to 7, containing a chelating agent, a surfactant, and a solvent, wherein the solvent consists of water.
9. A set of a polishing composition and a cleaner for use in the method according to any one of items 1 to 7, containing a polishing composition and a cleaner, wherein the polishing composition contains an abrasive and a polishing aid, wherein the cleaner contains a chelating agent, a surfactant, and a solvent, and wherein the solvent consists of water.
10. A method of removing a non-diamond abrasive and a polishing aid from a surface of a silicon carbide substrate polished using a polishing composition containing the non-diamond abrasive and the polishing aid, wherein the method contains the step of cleaning the silicon carbide substrate by using a cleaner, wherein the cleaner contains a chelating agent, a surfactant, and a solvent, and wherein the solvent consists of water.
11. A cleaner for cleaning a silicon carbide substrate polished using a polishing composition containing a non-diamond abrasive and a polishing aid, wherein the cleaner contains a chelating agent, a surfactant, and a solvent, and wherein the solvent consists of water.

### Examples

The present invention will be explained in more detail using the following Examples and Comparative Examples. However, the technical scope of the present invention is not limited only to the following Examples. Note that unless otherwise specified, "%" and "parts" mean "mass%" and "parts by mass", respectively. In addition, in the following Examples, unless otherwise specified, operations are performed under conditions at room temperature (20°C or more and 25°C or less)/relative humidity (RH) of 40%RH or more and 50%RH or less.

The pH of the cleaner was checked with a pH meter (e.g., a glass electrode type hydrogen ion concentration indicator (model No. F-23) manufactured by HORIBA, Ltd). In this measurement, a three-point calibration using standard buffers (phthalate pH buffer, pH: 4.01 (25°C); neutral phosphate pH buffer, pH: 6.86 (25°C); and carbonate pH buffer, pH: 10.01 (25°C)) was conducted. The glass electrode was then placed in the cleaner for 2 minutes or longer, and the value was measured after the pH had stabilized.

### (Example 1)

### [Preparation of polishing composition]

A polishing composition was prepared by mixing colloidal silica (average primary particle size: 35 nm) as an abrasive, potassium permanganate as a permanganate, aluminum nitrate nonahydrate as a metal salt A, and deionized water. The concentration (content) of each component in the polishing composition was 0.03 mass% for colloidal silica, 4 mass% for potassium permanganate, and 1.1 mass% for aluminum nitrate nonahydrate.

### [Polishing of polishing target]

A SiC wafer was used as a polishing target, and the polishing composition prepared above was used as a polishing liquid as it was, and polishing was performed under the following polishing conditions.

### <Polishing conditions>

Polishing equipment: Single-side polishing equipment, manufactured by FUJIKOSHI MACHINERY CORP., model "RDP-500"
Polishing pad: "IC1000", manufactured by NITTA DuPont Incorporated
Head: for 4-inch
Template: "TCI100" d=300 µm, manufactured by FUJIBO (Ehime) HOLDINGS, INC.
Processing pressure: 7.0 psi (48.26 kPa)
Head rotation speed: 130 rpm
Table rotation speed: 100 rpm
Polishing liquid feed rate: 20 mL/min (running stream)
Polishing time: 5 min
Polishing target: 4-inch SiC wafer (conduction type: n-type; crystal type 4H-SiC; off angle against the C-axis of a principal plane (0001): 4°), one wafer/batch
Temperature of polishing liquid: 20°C.

### <Pad dressing>

Pad dressing was performed before the above polishing. The pad dressing was performed as follows. First, a pad was brushed using a brush for 5 minutes with pure water running over the pad. Next, the brushed pad was diamond-dressed for 3 minutes. Finally, the diamond-dressed pad was brushed using a brush for 5 minutes.

### [Preparation of cleaner]

Citric acid as a chelating agent and sodium polyoxyethylene lauryl ether sulfate as a surfactant A (number of moles of ethylene oxide added: average 3; number of carbon atoms in alkyl groups: mixture of 12 to 14; aqueous solution in a concentration of 27 mass%; pH of undiluted solution: 8.6) were mixed in pure water to prepare a cleaner 1. The concentration (content) of each component in the cleaner was 1 mass% for citric acid and 27 mass% for the surfactant A. Meanwhile, the pH of the cleaner 1 was 2.0.

### [Cleaning]

The SiC wafer after polishing was cleaned by switching the polishing liquid to pure water and polishing for 30 seconds without removing the SiC wafer from the above polishing equipment. The SiC wafer was then cleaned by polishing the SiC wafer with the cleaner 1 prepared above at a flow rate of 100 ml/min and a cleaning duration of 1 minute, and under other conditions described in the polishing conditions above. Note that in order to add the cleaner 1 dropwise onto the SiC wafer surface, a tube for dropping a cleaner was installed at the same position as the tube for dropping a polishing composition in the polishing equipment, and the cleaner 1 was added dropwise using a tube pump.

After completion of the above cleaning, the SiC wafer was removed from the polishing equipment. After that, the SiC wafer was then transferred to a clean room and scrubbed with running water (pure water) using a commercially available PVA (polyvinyl alcohol) sponge under room temperature conditions. The wafer was further washed (overflow immersion) in running water (pure water) for 15 minutes or longer. Finally, the SiC wafer was dried using an air gun, and the following evaluations were conducted.

### (Example 2)

The preparation of a cleaner (cleaner 2) and the polishing and cleaning of the SiC wafer were performed in the same manner as in Example 1, except that the concentration of citric acid in the cleaner was set to 2 mass%. Note that the pH of the cleaner 2 was 2.0.

### (Example 3)

The preparation of a cleaner (cleaner 3) and the polishing and cleaning of the SiC wafer were performed in the same manner as in Example 2, except that nitric acid was further added to the cleaner to give a concentration of 1 mass%. Note that the pH of the cleaner 3 was 1.3.

### (Example 4)

The preparation of a cleaner (cleaner 4) and the polishing and cleaning of the SiC wafer were performed in the same manner as in Example 2, except that hydrogen peroxide was further added to the cleaner to give a concentration of 0.5 mass%. Note that the pH of the cleaner 4 was 2.0.

### (Example 5)

The preparation of a cleaner (cleaner 5) and the polishing and cleaning of the SiC wafer were performed in the same manner as in Example 2, except that polyoxyethylene isotridecyl ether (number of moles of ethylene oxide added: 9; alkyl group: isotridecyl group (number of carbon atoms: 13)) was used as a surfactant B instead of the surfactant A. Note that the pH of the cleaner 5 was 2.0.

### (Example 6)

The preparation of a cleaner (cleaner 6) and the polishing and cleaning of the SiC wafer were performed in the same manner as in Example 2, except that alkyl trimethyl ammonium chloride (alkyl group: hexadecyl group, stearyl group (number of carbon atoms: 16 to 18)) was used as a surfactant C instead of the surfactant A. Note that the pH of the cleaner 6 was 2.0.

### (Comparative Example 1)

The preparation of a cleaner (comparative cleaner 1) and the polishing and cleaning of the SiC wafer were performed in the same manner as in Example 2, except that the surfactant A was not added to the cleaner. Note that the pH of that comparative cleaner 1 was 2.0.

### (Comparative Example 2)

The polishing and cleaning of the SiC wafer was performed in the same manner as in Example 1, except that only pure water was used as the cleaner. Note that the pH of the cleaner (pure water, comparative cleaner 2) was 7.2.

### (Comparison Example 3)

The preparation of a cleaner (comparative cleaner 3) and the polishing and cleaning of the SiC wafer were performed in the same manner as in Example 1, except that citric acid was not added to the cleaner. Note that the pH of the comparative cleaner 3 was 8.6.

### (Comparison Example 4)

A cleaner (comparative cleaner 4) was prepared in the same manner as in Example 2, while using, as a solvent for the cleaner, acetone instead of water. However, in the comparative cleaner 4, the chelating agent was not dissolved and the surfactant became cloudy and ununiform, making it impossible to perform the pH measurement and cleaning after polishing.

### (Comparison Example 5)

A cleaner (comparative cleaner 5) was prepared in the same manner as in Example 2, while using, as a solvent for the cleaner, ethanol instead of water. However, in the comparative cleaner 5, the chelating agent was not dissolved and the surfactant became cloudy and ununiform, making it impossible to perform the pH measurement and cleaning after polishing.

### [Evaluation]

### <Uniformity of cleaner>

The uniformity of the cleaner was evaluated visually according to the following criteria:
A: visually clear; and
D: visually detected undissolved residues or cloudiness.

### <Aluminum cleaning performance>

The concentration of aluminum ions on the dried SiC wafer surface (Si surface, measurement region: circular region with a diameter of 30 mm) was measured using an X-ray fluorescence spectrometer (XRF) (Rigaku Corporation; model number: ZSX400), and the measured results were evaluated according to the following criteria. Grade A or B is considered to be practical:
A: below detection limit;
B: 1 × 10¹² atoms/cm² or more and less than 1 × 10¹³ atoms/cm²; and
D: 1 × 10¹³ atoms/cm² or more.

### <Particle cleaning performance>

The surface (C-surface) of the dried SiC wafer was observed at three locations in a 10 µm × 10 µm area by using an atomic force microscope (AFM; manufactured by Bruker; model: Nanoscope V), and the performance of cleaning particles on the observed surface was evaluated according to the following criteria. Grade A, B, or C is considered to be practical:
A: showing the best cleaning effect;
B: showing a good cleaning effect;
C: showing a certain level of cleaning effect; and
D: showing no cleaning effect.

Table 1 below shows the composition and evaluation results of the cleaners used in the respective Examples and Comparative Examples.

**[Table 1]**

| | Cleaner | | | | | | | | Cleaning duration (min) | Evaluation | | |
|---|---|---|---|---|---|---|---|---|---|---|---|---|
| | No. | Solvent | Chelating agent | | Surfactant | Additive | | pH | | Uniformity | Aluminum cleaning performance | Particle cleaning performance |
| | | | Kind | Concentration (mass%) | Kind | Kind | Concentration (mass%) | | | | | |
| Example 1 | 1 | H₂O | Citric acid | 1 | Surfactant A | - | - | 2.0 | 1 | A | B | A |
| Example 2 | 2 | H₂O | Citric acid | 2 | Surfactant A | - | - | 2.0 | 1 | A | A | A |
| Example 3 | 3 | H₂O | Citric acid | 2 | Surfactant A | Nitric acid | 1 | 1.3 | 1 | A | A | A |
| Example 4 | 4 | H₂O | Citric acid | 2 | Surfactant A | H₂O₂ | 0.5 | 2.0 | 1 | A | A | A |
| Example 5 | 5 | H₂O | Citric acid | 2 | Surfactant B | - | - | 2.0 | 1 | A | A | C |
| Example 6 | 6 | H₂O | Citric acid | 2 | Surfactant C | - | - | 2.0 | 1 | A | A | B |
| Comparative Example 1 | Comparative 1 | H₂O | Citric acid | 2 | - | - | - | 2.0 | 1 | A | A | D |
| Comparative Example 2 | Comparative 2 | H₂O | - | - | - | - | - | 7.2 | 1 | A | D | D |
| Comparative Example 3 | Comparative 3 | H₂O | - | - | Surfactant A | - | - | 8.6 | 1 | A | D | A |
| Comparative Example 4 | Comparative 4 | Acetone | Citric acid | 2 | Surfactant A | - | - | - | - | D | - | - |
| Comparative Example 5 | Comparative 5 | Ethanol | Citric acid | 2 | Surfactant A | - | - | - | - | D | - | - |

As clearly demonstrated in Table 1 above, it has been found that in the cases of the cleaning method in the Examples, aluminum ion residues and particle residues on the silicon carbide substrate can be sufficiently removed. By contrast, in the cases of the cleaning method in Comparative Examples 1 to 3, it has been found that at least one of the aluminum ion residues or particle residues cannot be sufficiently removed. In the cases of the cleaning method in Comparative Examples 4 to 5, the cleaner could be neither prepared nor evaluated because the solvent for the cleaner was an organic solvent.

The present application is based on Japanese Patent Application No. 2023-052626 filed on March 29, 2023, the disclosure of which is incorporated herein by reference in its entirety.

## Claims

1. A method of polishing and cleaning a silicon carbide substrate, the method comprising the steps of:
supplying a polishing composition to a silicon carbide substrate and polishing the silicon carbide substrate; and
cleaning the polished silicon carbide substrate by using a cleaner,
wherein the cleaner comprises a chelating agent, a surfactant, and a solvent, and
wherein the solvent consists of water.

2. The method according to claim 1, wherein the chelating agent comprises a hydroxy acid.

3. The method according to claim 1, wherein the surfactant comprises an anionic surfactant having a polyoxyalkylene unit.

4. The method according to claim 1, wherein the cleaner further comprises at least one of an inorganic acid or an oxidant.

5. The method according to claim 1, wherein the cleaner has a pH of less than 7.0.

6. The method according to claim 1, wherein the polishing composition comprises an abrasive and a polishing aid.

7. The method according to claim 6, wherein the abrasive comprises a non-diamond abrasive.

8. A cleaner for use in the method according to any one of claims 1 to 7, comprising a chelating agent, a surfactant, and a solvent,
wherein the solvent consists of water.

9. A set of a polishing composition and a cleaner for use in the method according to any one of claims 1 to 7, comprising a polishing composition and a cleaner,
wherein the polishing composition comprises an abrasive and a polishing aid,
wherein the cleaner comprises a chelating agent, a surfactant, and a solvent, and wherein the solvent consists of water.

10. A method of removing a non-diamond abrasive and a polishing aid from a surface of a silicon carbide substrate polished using a polishing composition containing the non-diamond abrasive and the polishing aid,
wherein the method comprises the step of cleaning the silicon carbide substrate by using a cleaner,
wherein the cleaner comprises a chelating agent, a surfactant, and a solvent, and wherein the solvent consists of water.

11. A cleaner for cleaning a silicon carbide substrate polished using a polishing composition containing a non-diamond abrasive and a polishing aid,
wherein the cleaner comprises a chelating agent, a surfactant, and a solvent, and
wherein the solvent consists of water.
